# EUROPEAN PATENT SPECIFICATION

(11) **EP 3 596 827 B1**
(45) Date of publication and mention of the grant of the patent: **11.05.2022**
(21) Application number: 18709047.7
(22) Date of filing: 13.03.2018
(51) Int. Cl.: H03K 17/96

(54) **CAPACITIVE SENSOR SWITCH WITH DISPLAY**
KAPAZITIVER SENSORSCHALTER MIT ANZEIGE
COMMUTATEUR DE CAPTEUR CAPACITIF À AFFICHAGE

(30) Priority: 13.03.2017 EP 17160601
(43) Date of publication of application: 22.01.2020
(73) Proprietor: Captron Electronic GmbH, 82140 Olching (DE)
(72) Inventor: BELLM, Reinhard, 82110 Germering (DE); HÜTTENHOFER, Kilian, 81247 München (DE)
(74) Representative: Lohr, Jöstingmeier & Partner
(86) International application number: PCT/EP2018/056261
(87) International publication number: WO 2018/167074

(56) References cited:
- EP-A1- 1 973 028
- EP-A2- 1 272 007
- WO-A1-01/29483
- DE-A1- 2 855 935
- DE-A1-102011 077 902
- DE-A1-102012 221 639
- DE-A1-102013 021 878
- DE-B3-102004 024 835
- US-A1- 2008 067 052
- US-B2- 6 685 031

## Description

### Field of the invention

The invention relates to a capacitive sensor switch with an integrated display unit and to a consignment system, also called a pick to light system with such a sensor switch.

### Description of the related art

In GB 1464 095, an input and display unit is disclosed. Input of setpoint values is done by sensor switches of a sensor surface with the functions "upwards", "downwards", and "off". A 7-segments display is arranged besides the sensor surface for displaying the preset value.

US 6,685,031 B2 discloses a display unit for a consignment system, wherein a mechanical check button is arranged in addition to a 7-segment display.

EP 1 973 028 A1 discloses a touch pad with multiple touch sensors and

DE 10 2011 077 902 A1 discloses a capacitive control and display panel for domestic appliances.

### Summary of the invention

The problem to be solved by the invention is to provide an input and output unit for a consignment system which is also known as a pick to light system, which is robust, easy to mount, and easy to operate. A further aspect of the invention is the design of a consignment system with a corresponding input and output unit or user interface.

Insertion page 1a, to be inserted at the end of paragraph *"Description of the related art"* on page 1.

US 2008/0067052 A1 and DE 10 2013 021878 A1 disclose a switch comprising capacitive sensing means.

DE 10 2012 221639 A1 discloses a bar display.

DE 10 2004 024835 B3 discloses a sensor for controlling a hob in a kitchen appliance.

EP 1 272 007 A2 discloses a further hob in a kitchen appliance.

DE 28 55 935 A1 discloses a keyboard and a display.

WO 01/29483 A1 discloses an electronic gas cook top control with simmer system.

Solutions of the problem are described in the independent claims. The dependent claims relate to further improvements of the invention.

In a preferred embodiment, the input and output unit serving as a user interface comprises a capacitive sensor switch with an integrated display unit for displaying letters and/or digits. Generally, sensor switches are switching elements, which deliver a signal upon touching, preferably with a finger or a hand. This signal has in general the information content of 1 bit, i.e. it is mostly an on/off signal. Here, sensor switches differ significantly from touch sensitive screens used as monitors or display in Smartphones. The sensor signal which is output by the touch sensor of such a screen, is in general a high-resolution position signal, which enables to locate as accurate as possible one or more fingers resting on the screen. For this purpose, a complex and filigree sensor technique is necessary. The sensor switch disclosed herein can be designed much more simple, as the presence of only one finger has to be displayed.

With respect to robustness, there are significant differences between a switch being used in general in an industrial or commercial field, and a screen. A switch must withstand strong impacts or shocks without being damaged. Furthermore, a switch is often exposed to unfavorable environmental conditions such as high air humidity, or high and/or low temperatures. For this reason, switches are often manufactured with stainless steel housings. Screens and in particular displays of Smartphones are normally treated very carefully. In order to reach a high local resolution, the distance from the sensor to the finger, i.e. inter alia the thickness of the glass there-between, should be as small as possible. This results in a significantly lower mechanical stability when compared to a switch. In a consignment system, it might occur that a heavy object falls on a switch. The switch must not be damaged thereby. This is not the case with a mobile phone.

The sensor switch does not comprise mechanically movable parts. Thus, it may be integrated into a completely closed housing. Thereby, the sensor switch may be water-proof. The housing has a front side through which the switch may be operated and an opposing rear side through which the switch may be mounted and/or which may hold electrical connectors.

A capacitive sensor switch comprises a housing with a front side and a rear side. The front side is the sensor side through which the switch is operated and by which it displays information while the rear side may be a mounting side. There may also be double-sided switches which have a sensor at the rear side.

The sensor switch comprises a sensor assembly which further comprises a printed circuit board (PCB) and a cover disk. The PCB has at least one sensor area which may be connected to a sensor circuit. The cover disk is on the printed circuit board and is oriented towards the front side. It is preferred if the switch has a sensor surface being as large as possible, such that said switch possesses a high sensitivity and may also identify a finger in a glove. A single sensor or a differential sensor may be provided in order to reach better sensitivity and/or better suppression of interference signals.

For displaying information, in particular a number of pieces that should be taken from or put into a container, for example, preferably a display is provided. This display is preferably a simple display with high brightness and great contrast, for example a 7-segment LED (Light Emitting Diode) display or a segment display with another number of segments, for example 9,14, or 16 or a dot matrix display. This display may be configured for different colors. This may allow several persons, each person with its individually assigned color, to simultaneously operate at the consignment system. The same applies for the LED outer ring, which is preferably based on RGB LEDs and enables the client to display individual colors for the consigner or for operating states. Preferably, the LEDs are arranged on the PCB.

The display may be integrated into the sensor area. That means that touching the display may trigger a switching activity of the switch. Thus, the switch may be embodied more compact, as no adjacent operation or display surfaces are necessary. Furthermore, the sensor surface may be designed larger.

Furthermore, there is a sensor circuit and a sensor area connected to the sensor circuit, preferably on the PCB. The sensor circuit may detect the presence of a conductive object, for example a finger or a hand in close proximity to the sensor area. The detection distance may be in a range from 0 mm (directly on the sensor area) to 30 mm above the sensor area. It may also be in a range from 0 mm to 10 mm or 5 mm. For detection an electric signal like a HF or RF signal may be fed into the sensor area and changes in signal level by capacitive coupling to the object may be evaluated. The sensor area may comprise multiple sections. There may be radially arranged sections. An inner section may bae a main sensing section, while a surrounding section may be a guard or reference section.

The cover disk comprises a dielectric material like a plastic material. Such a dielectric material improves coupling of the electric field from the sensor area to the object.

The cover disk has an electrically conductive surface. The cover disk may comprise for example a metal, preferably a metal foil, a plastic part having a metallized surface or a plastic part comprising electrically conductive particles. The electrically conductive surface may also be thicker than a foil or, respectively, may have reinforcements, such that it forms a mechanical protection for the display lying behind said surface. Preferably, a protective panel, in particular comprising polycarbonate, is additionally provided in front of the electrically conductive surface. The cover disk may have a thickness in a range of 0.5 to 8 mm, preferably between 1 and 3 mm. The cover disk may have a constant thickness (not considering the channels, pins and recesses). The disk may have a contour adapted to the sensor switch. It may have a round shape and may have a diameter between 30 and 80 mm. The cover disk is capacitively coupled or galvanically connected to the sensor area and/or the sensor circuit.

The cover disk further provides a plurality of light channels for example as through-holes, to guide light from the at least one LED to the front side of the switch. The light channels may be empty channels or spaces within the disk, having sidewalls of the cover disk's material. At least one of the LEDs may be within the light channels or even slightly below the light channels, if there is a gap between the cover disk and the PCB. The sidewalls may also have a light or white or mirrored surface. The channels may also be filled with an optical conductive material.

There may be an optical sensor, e.g. a photodiode in at least one of the light channels. The optical sensor may be alone or together with a LED in a light channel. The optical sensor may be used to detect the presence of many objects, e.g. a finger or a hand above the channel. Therefore, the optical sensor may be or may be used as an optical proximity sensor. The optical sensor may have a higher spatial resolution as the capacitive sensor and therefore may allow to detect a specific position e.g. a digit or ring segment to be touched. Furthermore, the reliability of detection may be improved by correlating optical and capacitive signal detection.

The switch may comprise a simple switching output, for example for outputting a voltage impulse, or with a switching contact, for example a relay contact. It is preferred if the switch comprises a network and/or bus interface. Said interface may be an RS485 interface.

The bus interface may allow to interconnect a plurality of switches with one another and/or with a control unit. The switch may be controlled and/or be parameterized via the bus interface. For example, the switching function of the switch (press function, switching function or static activation) may be selected. Numeric values and/or letters, preferably also a ticker may be controlled. Furthermore, additional display functions, for example color selection, flashing, different brightness grades, or a timely variable display may be configured.

The display of the switch may also comprise further display elements, as dots or at least one circle or circular arc being circumferential at the edge of the switch. Such a circle or arc may be divided into several segments, wherein the complete circle and/or the segments may be controllable by the interface. Besides the above described controlling functions, the circle may also represent a circumferential display. Herein the term digit display is used for simplicity, although such a display may in general display digits, numbers, letters and other symbols. Therefore, multiple LEDs are arranged such, that they form at least a digit or a number or a circle or a section thereof.

The switch may have a wireless interface. Such an interface may be an NFC interface (Near Field Communication), which could for example implement one of the standards SO/IEC 13157, -16353, -22536, -28361.

Thus, a communication of the switch with a smartphone may be possible. In this way, for example settings may be configured. In use in a logistics system, the position of the person at a switch could thereby be detected. An authentication may also be conducted. Furthermore, it may be detected and stored, which person has operated which switch.

The switch may comprise means for detecting gestures. For example, an indicated numeral value may be changed by simple gestures. Such a gesture may be, moving a finger from left to right in order to increase the numeral value, or from right to left to reduce the numeral value. For the evaluation of said gestures, it is not necessary to implement a complex touch-sensitive display, as for example in Smartphones. Here, the sensor in the switch must be robust, simple and reliable. To recognize a movement in two directions, a division of the sensor surface in two or four sensor surfaces would be sufficient. These could be semicircular with a vertical division in the case of a round sensor switch. If now at first the left sensor surface detects a finger, whereby later the finger will be detected from both sensor surfaces simultaneously, and then is detected only from the right sensor surface, this could be recognized as moving over the sensor from the left to the right. In this way, different simple gestures may be detected with sufficient precision. It would also be possible to enter numerals or simple letters in a simple way by drawing them onto the surface with a finger.

A consignment system may comprise several capacitive sensor switches with an integrated display, as described herein. These may be connected to one another as well as to a control unit. The switches may preferably be connected in series with other switches in order to keep the cabling as short as possible, which is a significant advantage especially with larger systems.

A further aspect relates to a method for operating a consignment system. Several sensor switches are assigned to or associated with different goods containers, trays or goods storage places. According to a consignment order, the control unit controls the displays of the sensor switches in such a way that a number, a mass or another unit of the goods to be consigned is indicated. A person compiling or distributing the goods may easily recognize by means of the display of the sensor switch, which goods are needed or to be picked in which quantity, or are to be put in which storage place. As soon as the corresponding quantity is provided, the person may touch the surface of the sensor switch for acknowledgement, or may perform a certain gesture on the surface. As soon as the sensor switch detects this, it may give a signal to the control unit. In this way, the control unit may follow up the execution of the order.

In further embodiments not covered by the claims, the indicated number or quantity may be changed on the sensor switch for example by touching certain partial surfaces or by gestures. This may be transmitted to the control unit. Thereby, changed quantities or also shortfalls may be registered. In addition, an identification or authentication of the person may be conducted via NFC, for example by a mobile phone or mobile data entry (MDE) device held against the sensor switch.

### Description of Drawings

In the following the invention will be described by way of example, without limitation of the general inventive concept, on examples of embodiment with reference to the drawings.
Figure 1 shows a front view of a capacitive sensor switch.
Figure 2 shows an embodiment from the rear side
Figure 3 shows a sectional side view of an embodiment.
Figure 4 shows details of the sensor assembly.
Figure 5 shows a further sectional view of the sensor assembly.
Figure 6 shows an enlarged section of the ring display.
Figure 7 shows the interior of a ring channel in more detail.
Figure 8 shows details of a cover disk.
Figure 9 shows a PCB.
Figure 10 shows an embodiment of a sectioned cover disk.
Figure 11 shows a further sectioned cover disk.
Figure 12 shows a consignment system.
Figure 13 shows a flow chart of a method of operating a consignment system.

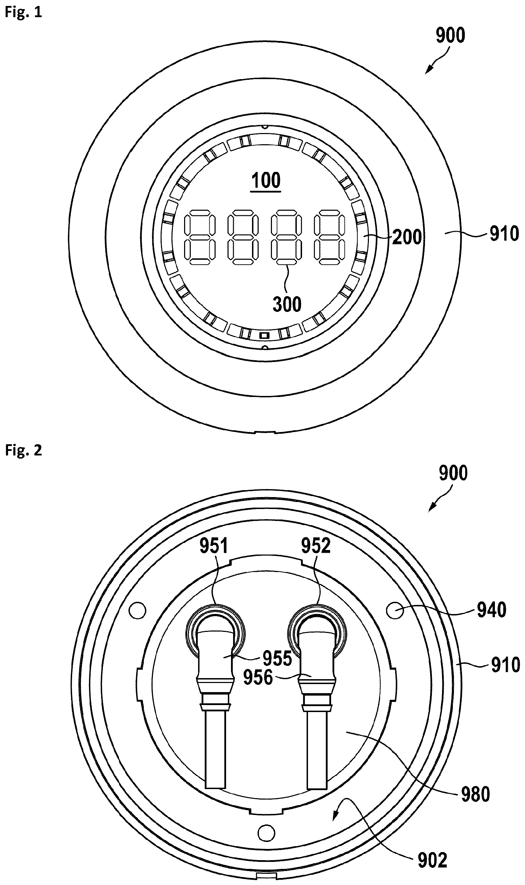

In figure 1 a front side 901 of a capacitive sensor switch 900 of a preferred embodiment according to the invention is shown. It comprises a housing 910 which further comprises a sensor assembly 100 from which a ring-shaped display 200 and a digit display 300 are shown. There may be any other types of display and any combination thereof.

In figure 2, an embodiment of the sensor switch 900 as seen from the rear side 902 is shown. There may be fixation means 940, for example screw holes which may either be suitable for self-tapping screws or may have a thread. Furthermore, there may be connectors for connecting a power supply and/or a bus or a network. It is preferred to have two connectors as shown in this example to allow daisy chaining of a bus. There may be a first bus connector 951 for a first cable connector 955 and a second bus connector 952 for a second cable connector 956. The rear side may either have a cover or may comprise a casting compound 980. It is preferred, if the interior of the housing, but preferably not the light channels, is filled with a casting compound.

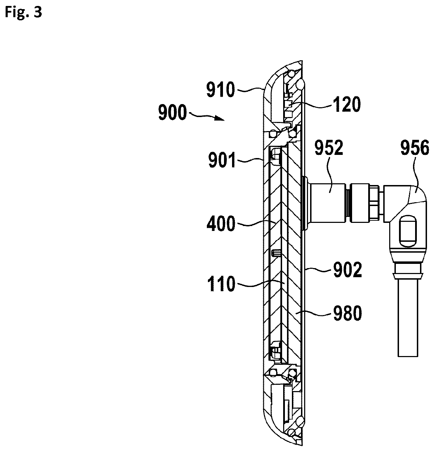

In figure 3, a sectional side view of an embodiment of a capacitive sensor switch 900 is shown. It is a vertical section at the center of Figure 1. Here, the details of the sensor assembly are shown. A printed circuit board (PCB) 110 holds a sensor circuit 120. A cover disk 400 is mounted on top of the printed circuit board. Preferably, the cover disk shows a space between the printed circuit board 110 and the housing 910.

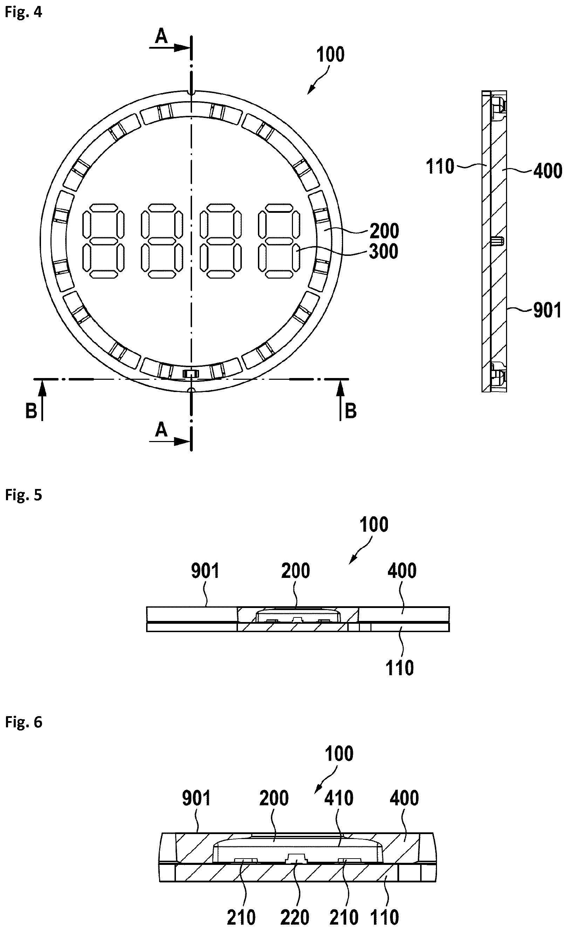

In figure 4, details of the sensor assembly 100 are shown in a front view as seen from the front side 901 at the left part of the figure. The right part of the figure shows a sectional view as marked by the letters A-A. The ring display 200 comprises a plurality of ring segments - in this embodiment there are eight segments -which may be illuminated by LEDs. The digit display 300 comprises a couple of digits, for example 4 digits. In this embodiment, 7-segment digits are shown, wherein the individual segments of the digits may be illuminated by LEDs to display desired digits.

In figure 5, a further sectional view of the sensor assembly 100 along the line B-B is shown. The section of the ring display 200 is shown enlarged and with more detail in the following Figures.

In figure 6, an enlarged section of the ring display 200 is shown. Here a section of a ring channel 410 is shown enlarged. Basically, any of the ring light channels 410 and the digit light channels 420 may be built as described herein.

On the PCB 110 and within the ring light channel 410, there is at least one LED 210. In this embodiment, two LEDs are shown to increase light intensity and to improve light distribution over the length of the channel. Basically, any number of LEDs may be used in a channel. The LEDs may be single color or multi-color types like RGB LEDs or a combination thereof. Furthermore, an optical sensor like a photodiode 220 may be provided. This photodiode may be an infrared diode or any other suitable diode, phototransistror or integrated sensor. It may be used to detect the presence of any object, like a finger or a hand above the channel. Therefore, the optical sensor may be or may be used as an optical proximity sensor. Such an optical sensor may be used to detect the presence of a finger above one of the ring channels with a higher resolution than the capacitive sensor. Furthermore, the reliability of detection may be improved by correlating optical and capacitive signal detection. Depending on the presence of a finger above a ring channel, the reflective properties are changed, and therefore the photo diode 220 receives a different amount of light which may either be ambient light or light from the LEDs. Such a difference in light may be detected and evaluated to generate a control signal. Preferably such a photo diode is coupled to the sensor circuit 120.

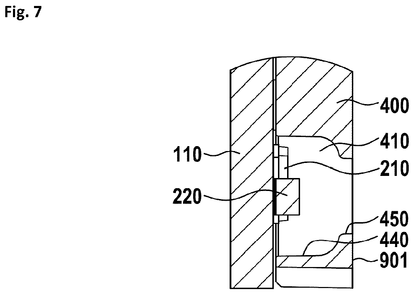

In figure 7, the interior of a ring channel 410 is shown in more detail in a side view. Basically, the digit light channels 420 are built the same way. Here, an LED 210 is shown besides or behind a photodiode 220. Each channel has at least one inner wall 440 which may have reflective properties. At the outer end (distant from the LED and the PCB) there is an edge 450 which defines the contour of a symbol to be displayed. The contour may either be a segment of the ring display or a segment of the digit display.

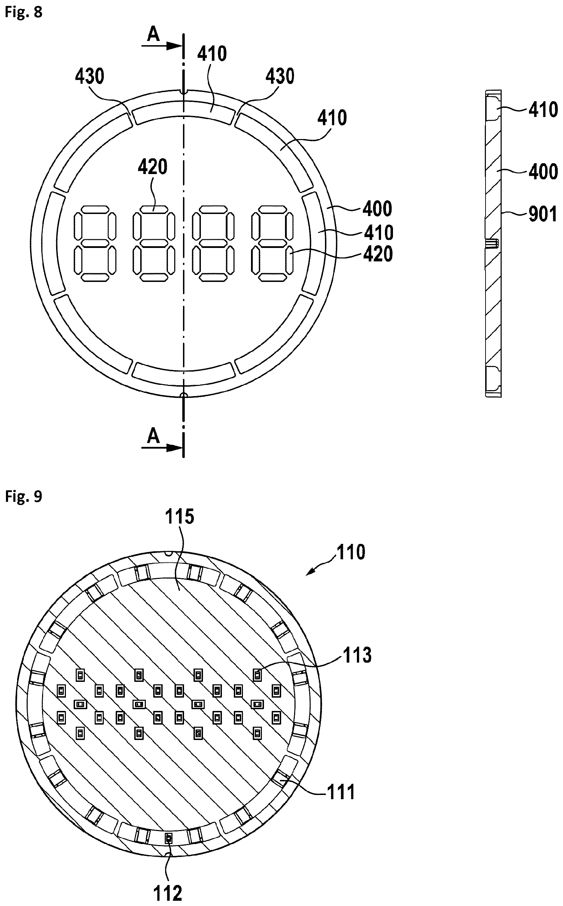

In figure 8, details of a cover disk 400 are shown in a front view as seen from the front side 901 at the left part of the figure. The right part of the figure shows a sectional view as marked by the letters A-A. The ring light channels 410 define a ring and the digit light channels 420 define digits. All light channels are separated by sidewalls 430.

In figure 9, a PCB 110 (printed circuit board) is shown in a top view from the front side. Here, ring LEDs 111 for illuminating the ring display 200 may be provided. Also, digit LEDs 113 for illuminating the digit display 300 may be provided. The digit LEDs may be smaller than the ring LEDs as they have to illuminate a smaller area and therefore need a smaller power. RGB LEDs may have a larger size than monochrome LEDs. There may be one or a plurality of photodiodes 112. Furthermore, a sensor area 115 may be provided. Preferably, this sensor area covers most of the surface of the PCB. The sensor area is coupled to a sensor circuit 120 for evaluation of signals at the sensor area. The sensor circuit may detect the presence of a conductive object, for example a finger or a hand in close proximity to the sensor area. The detection distance may be in a range from 0 mm (directly on the sensor area) to 30 mm above the sensor area. It may also be in a range from 0 mm to 10 mm or 5 mm. For detection an electric signal like a HF or RF signal may be fed into the sensor area and changes in signal level by capacitive coupling to the object may be evaluated.

The sensor area may comprise multiple radially arranged sections. An inner section may be a main sensing section, while a surrounding section may be a guard or reference section. The inner section may cover the area within the ring LEDs 111, while the surrounding section may be the area outside the ring LEDs.

As shown in figure 4, a cover disk 400 is provided above the PCB 110. Therefore, the cover plate is between the object and the sensor area. The cover plate comprises a dielectric material like a plastic material. Such a dielectric material improves coupling of the electric field from the sensor area to the object. A further improvement is made by using an electrically conductive cover plate.

Such a cover plate may comprise a metal or a plastic body having a metallized surface. This cover plate may be electrically connected to the sensor area. In most cases capacitive coupling to the sensor area would be sufficient, as the cover plate may be arranged directly above the sensor area.

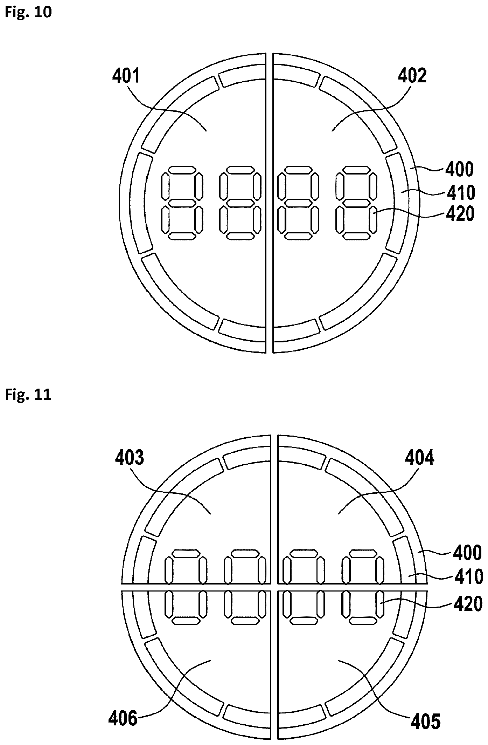

In figure 10, a sectioned cover disk is shown. Here, the cover disk is separated into two parts by a vertical separation forming a left section 401 and a right section 402. Such a sectioned cover disk allows to localize the presence of a finger or another object to a section. In this embodiment, it may be detected whether a finger is over the left section 401 or the right section 402. This and other similar embodiments may be combined with a radial arrangement as disclosed above.

In figure 11, a further sectioned cover disk comprising four sections is shown. In this embodiment, there is a horizontal and a vertical separation between the cover disks forming four equally shaped sections 403, 404, 405, and 406. It is obvious that there may be any other numbers of cover disk sections. Also, the shape may be varied according to the requirements.

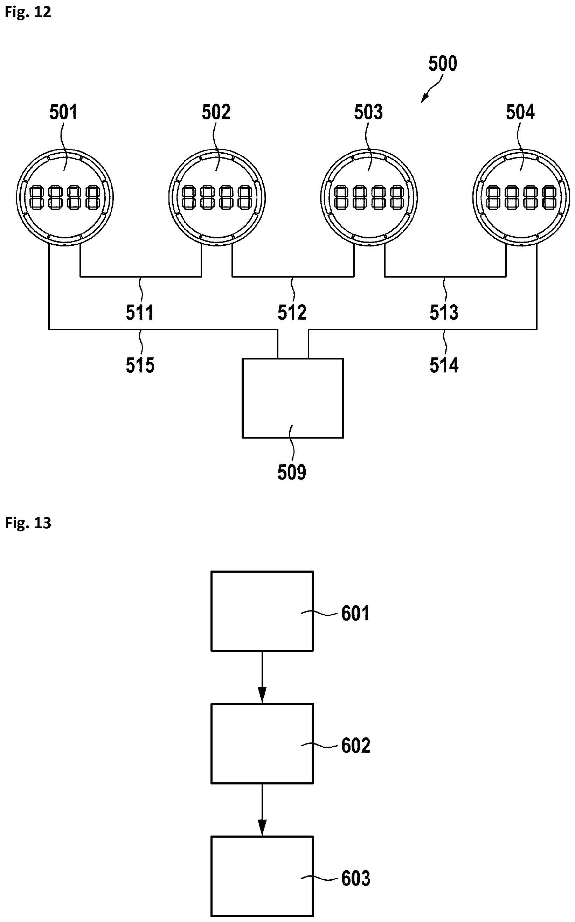

In figure 12, a consignment system 500 is shown. The consignment system comprises four capacitive sensor switches 501, 502, 503, and 504 together with a control unit 509. The capacitive sensor switches and the control unit are connected together by bus lines 511, 512, 513, 514, and 515 to a ring bus, such that they can communicate with each other.

In figure 13, a flow chart of a method of operating a consignment system is shown. In the first step 601, at least one capacitive sensor switch is assigned to a goods container, a tray, or a goods storage place. In the following step 602, the display of a capacitive sensor switch is controlled by a control unit to indicate the quantity of goods to be picked. In the following step 603, a signal to the control unit is generated to indicate that a capacitive sensor switch has been touched.

### List of reference numerals

- 100: Sensor assembly
- 110: PCB (printed circuit board)
- 111: ring LED
- 112: photodiode
- 113: digit LED
- 115: sensor area
- 120: sensor circuit
- 200: ring display
- 210: LED
- 220: optical sensor
- 300: digit display
- 400: cover disk
- 401-406: disk sections
- 410: ring light channels
- 420: digit light channels
- 430: sidewalls
- 440: channel inner wall
- 450: channel edge
- 500: consignment system
- 501- 504: capacitive sensor switches
- 509: control unit
- 511-515: bus lines
- 601- 603: method steps
- 900: sensor switch
- 901: front side
- 902: rear side
- 910: housing
- 940: fixation means
- 951: first bus connector
- 952: second bus connector
- 955: first cable connector
- 956: second cable connector
- 980: casting compound

## Claims

1. Capacitive sensor switch (900) comprising a housing (910) with a front side (901) and a rear side (902), the housing including a sensor assembly (100), wherein the sensor assembly (100) further comprises:
- a printed circuit board (110) comprising a sensor circuit (120), a sensor area (115) and a plurality of LEDs (210) positioned on the printed circuit board (110), the sensor area (115) being connected to the sensor circuit (120) and
- a cover disk (400) arranged on the printed circuit board (110) above the sensor area (115) and oriented towards the front side (901)
wherein the cover disk (400) comprises a dielectric material, the cover disk (400) comprises a plurality of light channels (410, 420) extending through the cover disk (400) and at least one of the plurality of LEDs (210) is arranged within a light channel (410, 420)
wherein the cover disk (400) comprises an electrically conductive surface, and the cover disk (400) is capacitively coupled or galvanically connected to the sensor circuit (120).

2. Capacitive sensor switch (900) according to any of the previous claims, **characterized in that**,
at least one light channel (410, 420) through the cover disk (400) extends from the printed circuit board (110) to the front side (901).

3. Capacitive sensor switch (900) according to any of the previous claims, **characterized in that**,
the cover disk (400) comprises at least one sidewall (430) between at least two light channels (410, 420).

4. Capacitive sensor switch (900) according to any of the previous claims, **characterized in that**,
a ring display (200) comprising multiple arc shaped segments, with each segment comprising at least one of the plurality of LEDs (210) arranged within a light channel (410) is provided.

5. Capacitive sensor switch (900) according to any of the previous claims, **characterized in that**,
a digit display (300) comprising multiple display segments arranged to form at least a digit or number, with each segment comprising at least one of the plurality of LEDs (210) arranged within a light channel (420) is provided.

6. Capacitive sensor switch (900) according to any of the previous claims, **characterized in that**,
at least one optical sensor (220), preferably an optical proximity sensor is positioned on the printed circuit board (110) and within a light channel (410, 420).

7. Capacitive sensor switch (900) according to any of the previous claims, **characterized in that**,
the electrically conductive surface of the cover disk (400) and/or the sensor area (115) comprises multiple conductive sections (401- 406), insulated from each other and individually connected to the sensor circuit (120).

8. Capacitive sensor switch (900) according to any of claims 2 to 7, **characterized in that**,
the sensor circuit (120) has means for detecting at least one of the presence, the direction, the speed of movement of a conductive object in close proximity to the electrically conductive surface of the cover disk and/or an electrically conductive material connected to the sensor circuit and/or the sensor area and/or the optical sensor (220).

9. Capacitive sensor switch (900) according to any of the previous claims, **characterized in that**,
the sensor switch comprises a bus or network interface (951, 952).

10. Capacitive sensor switch (900) according to any of the previous claims, **characterized in that**,
the rear side (902) comprises at least one fixation means (940) or the rear side (902) comprises a second sensor assembly (100).

11. Consignment system (500) comprising a plurality of capacitive sensor switches (501 - 504) with a digit display (300) and an optional ring display (200) and further comprising a control unit (509) wherein the capacitive sensor switches (501- 504) are capacitive sensor switches according to claims 5 or 6.

12. Consignment system (500) according to the previous claim, **characterized in that**,
the capacitive sensor switches (501 - 504) are interconnected and further connected to the control unit (509) by bus lines (511 - 515) forming a network and preferably a ring network.

13. Method of operating a consignment system according to claim 11 or 12, comprising the steps of:
a) assigning at least one capacitive sensor switch (501 - 504) to a goods container, tray or goods storage place,
b) controlling the displays of the capacitive sensor switches (501 - 504) by a control unit (509) to indicate the quantity of goods to be picked,
c) transferring of a signal to the control unit, indicating that a capacitive sensor switch has been touched to the control unit.

## Patentansprüche

1. Kapazitiver Sensorschalter (900) umfassend ein Gehäuse (910) mit einer Vorderseite (901) und einer Rückseite (902), wobei das Gehäuse eine Sensoranordnung (100) umfasst, wobei die Sensoranordnung (100) weiterhin umfasst:
- eine Leiterplatte (110) umfassend eine Sensorschaltung (120), einen Sensorbereich (115) und eine Vielzahl von auf der Leiterplatte (110) positionierten LEDs (210), wobei der Sensorbereich (115) mit der Sensorschaltung (120) verbunden ist und
- eine Abdeckscheibe (400), die auf der Leiterplatte (110) oberhalb des Sensorbereichs (115) angeordnet und zur Vorderseite (901) ausgerichtet ist,
wobei die Abdeckscheibe (400) ein dielektrisches Material umfasst,
die Abdeckscheibe (400) eine Vielzahl von Lichtkanälen (410, 420) umfasst, welche sich durch die Abdeckscheibe (400) erstrecken und
zumindest eine aus der Vielzahl von LEDs (210) in einem Lichtkanal (410, 420) angeordnet ist,
wobei die Abdeckscheibe (400) eine elektrisch leitfähige Oberfläche umfasst, und
die Abdeckscheibe (400) mit der Sensorschaltung (120) kapazitiv gekoppelt oder galvanisch verbunden ist.

2. Kapazitiver Sensorschalter (900) nach einem der vorhergehenden Ansprüche,
**dadurch gekennzeichnet, dass**
mindestens ein Lichtkanal (410, 420) sich durch die Abdeckscheibe (400) von der Leiterplatte (110) hin zur Vorderseite (901) erstreckt.

3. Kapazitiver Sensorschalter (900) nach einem der vorhergehenden Ansprüche,
**dadurch gekennzeichnet, dass**
die Abdeckscheibe (400) mindestens eine Seitenwand (430) zwischen mindestens zwei Lichtkanälen (410, 420) umfasst.

4. Kapazitiver Sensorschalter (900) nach einem der vorhergehenden Ansprüche,
**dadurch gekennzeichnet, dass**
eine ringförmige Anzeige (200) vorgesehen ist, welche mehrere bogenförmige Segmente umfasst, wobei jedes Segment mindestens eine aus der Vielzahl von LEDs (210) umfasst, welche in einem Lichtkanal (410) angeordnet sind.

5. Kapazitiver Sensorschalter (900) nach einem der vorhergehenden Ansprüche,
**dadurch gekennzeichnet, dass**
eine Ziffernanzeige (300) vorgesehen ist, welche mehrere Anzeigesegmente umfasst, die so angeordnet sind, dass sie mindestens eine Ziffer oder Zahl bilden, wobei jedes Segment mindestens eine aus der Vielzahl von LEDs (210) in einem Lichtkanal (420) umfasst, welche innerhalb eines Lichtkanals (420) angeordnet sind.

6. Kapazitiver Sensorschalter (900) nach einem der vorhergehenden Ansprüche,
**dadurch gekennzeichnet, dass**
mindestens ein optischer Sensor (220), vorzugsweise ein optischer Näherungssensor, auf der Leiterplatte (110) und in einem Lichtkanal (410, 420) positioniert ist.

7. Kapazitiver Sensorschalter (900) nach einem der vorhergehenden Ansprüche,
**dadurch gekennzeichnet, dass**
die elektrisch leitfähige Oberfläche der Abdeckscheibe (400) und/oder der Sensorbereich (115) mehrere voneinander isolierte und einzeln mit der Sensorschaltung (120) verbundene leitfähige Abschnitte (401- 406) umfasst.

8. Kapazitiver Sensorschalter (900) nach einem der Ansprüche 2 bis 7,
**dadurch gekennzeichnet, dass**
die Sensorschaltung (120) Mittel zum Erfassen von mindestens einem von der Anwesenheit, der Richtung, der Bewegungsgeschwindigkeit eines leitfähigen Objekts in unmittelbarer Nähe der elektrisch leitfähigen Oberfläche der Abdeckscheibe und/oder eines mit der Sensorschaltung verbundenen elektrisch leitfähigen Materials und/oder des Sensorbereichs und/oder des optischen Sensors (220) hat.

9. Kapazitiver Sensorschalter (900) nach einem der vorhergehenden Ansprüche,
**dadurch gekennzeichnet, dass**
der Sensorschalter eine Bus- oder Netzwerkschnittstelle (951, 952) umfasst.

10. Kapazitiver Sensorschalter (900) nach einem der vorhergehenden Ansprüche,
**dadurch gekennzeichnet, dass**
die Rückseite (902) mindestens ein Befestigungsmittel (940) umfasst oder die Rückseite (902) eine zweite Sensoranordnung (100) umfasst.

11. Kommissioniersystem (500) umfassend eine Vielzahl von kapazitiven Sensorschaltern (501 - 504) mit einer Ziffernanzeige (300) und einer optionalen Ringanzeige (200) und weiterhin umfassend eine Steuereinheit (509), wobei die kapazitiven Sensorschalter (501 - 504) kapazitive Sensorschalter nach den Ansprüchen 5 oder 6 sind.

12. Kommissioniersystem (500) nach dem vorhergehenden Anspruch,
**dadurch gekennzeichnet, dass**
die kapazitiven Sensorschalter (501 - 504) miteinander verbunden und weiterhin mit der Steuereinheit (509) durch Busleitungen (511 - 515) verbunden sind, die ein Netzwerk und vorzugsweise ein Ringnetzwerk bilden.

13. Verfahren zum Betreiben eines Kommissioniersystems nach Anspruch 11 oder 12, umfassend die Schritte:
a) Zuordnen mindestens eines kapazitiven Sensorschalters (501- 504) zu einem Warenbehälter, Tablett oder Warenlagerplatz,
b) Steuern der Anzeigen der kapazitive Sensorschalter (501 - 504) durch eine Steuereinheit (509) um die Menge der aufzunehmenden Waren anzuzeigen,
c) Übermittlung eines Signals an die Steuereinheit, das der Steuereinheit anzeigt, dass ein kapazitiver Sensorschalter berührt wurde.

## Revendications

1. Commutateur de capteur capacitif (900) comprenant un boîtier (910) avec un côté avant (901) et un côté arrière (902), le boîtier comportant un ensemble capteur (100), dans lequel l'ensemble capteur (100) comprend en outre :
- une carte de circuit imprimé (110) comprenant un circuit de capteur (120), une zone de capteur (115) et une pluralité de DEL (210) positionnées sur la carte de circuit imprimé (110), la zone de capteur (115) étant connectée au circuit de capteur (120) et
- un disque couvrant (400) agencé sur la carte de circuit imprimé (110) au-dessus de la zone de capteur (115) et orienté vers le côté avant (901),
dans lequel le disque couvrant (400) comprend un matériau diélectrique, le disque couvrant (400) comprend une pluralité de canaux de lumière (410, 420) s'étendant à travers le disque couvrant (400) et
au moins l'une de la pluralité de DEL (210) est agencée au sein d'un canal de lumière (410, 420)
dans lequel
le disque couvrant (400) comprend une surface électriquement conductrice, et
le disque couvrant (400) est couplé capacitivement ou connecté galvaniquement au circuit de capteur (120).

2. Commutateur de capteur capacitif (900) selon l'une quelconque des revendications précédentes, **caractérisé en ce que**,
au moins un canal de lumière (410, 420) à travers le disque couvrant (400) s'étend de la carte de circuit imprimé (110) au côté avant (901).

3. Commutateur de capteur capacitif (900) selon l'une quelconque des revendications précédentes, **caractérisé en ce que**,
le disque couvrant (400) comprend au moins une paroi latérale (430) entre au moins deux canaux de lumière (410, 420) .

4. Commutateur de capteur capacitif (900) selon l'une quelconque des revendications précédentes, **caractérisé en ce que**,
un afficheur annulaire (200) comprenant de multiples segments en forme d'arc, chaque segment comprenant au moins l'une de la pluralité de DEL (210) agencées au sein d'un canal de lumière (410), est fourni.

5. Commutateur de capteur capacitif (900) selon l'une quelconque des revendications précédentes, **caractérisé en ce que**,
un afficheur numérique (300) comprenant de multiples segments d'affichage agencés pour former au moins un chiffre ou un nombre, chaque segment comprenant au moins l'une de la pluralité de DEL (210) agencées au sein d'un canal de lumière (420), est fourni.

6. Commutateur de capteur capacitif (900) selon l'une quelconque des revendications précédentes, **caractérisé en ce que**,
au moins un capteur optique (220), de préférence un capteur de proximité optique, est positionné sur la carte de circuit imprimé (110) et au sein d'un canal de lumière (410, 420).

7. Commutateur de capteur capacitif (900) selon l'une quelconque des revendications précédentes, **caractérisé en ce que**,
la surface électriquement conductrice du disque couvrant (400) et/ou la zone de capteur (115) comprennent de multiples sections conductrices (401 à 406), isolées les unes des autres et connectées individuellement au circuit de capteur (120).

8. Commutateur de capteur capacitif (900) selon l'une quelconque des revendications 2 à 7, **caractérisé en ce que**,
le circuit de capteur (120) comporte des moyens pour détecter au moins l'une parmi la présence, la direction, la vitesse de déplacement d'un objet conducteur à proximité étroite de la surface électriquement conductrice du disque couvrant et/ou d'un matériau électriquement conducteur connecté au circuit de capteur et/ou à la zone de capteur et/ou au capteur optique (220).

9. Commutateur de capteur capacitif (900) selon l'une quelconque des revendications précédentes,
**caractérisé en ce que**,
le commutateur de capteur comprend un bus ou une interface réseau (951, 952).

10. Commutateur de capteur capacitif (900) selon l'une quelconque des revendications précédentes, **caractérisé en ce que**,
le côté arrière (902) comprend au moins un moyen de fixation (940) ou le côté arrière (902) comprend un second ensemble capteur (100).

11. Système d'expédition (500) comprenant une pluralité de commutateurs de capteur capacitif (501 à 504) dotés d'un afficheur numérique (300) et d'un afficheur annulaire facultatif (200) et comprenant en outre une unité de commande (509), dans lequel les commutateurs de capteur capacitif (501 à 504) sont des commutateurs de capteur capacitif selon les revendications 5 ou 6.

12. Système d'expédition (500) selon la revendication précédente,
**caractérisé en ce que**,
les commutateurs de capteur capacitif (501 à 504) sont interconnectés et en outre connectés à l'unité de commande (509) par des lignes de bus (511 à 515) formant un réseau et de préférence un réseau annulaire.

13. Procédé de fonctionnement d'un système d'expédition selon la revendication 11 ou 12, comprenant les étapes de :
a) attribution d'au moins un commutateur de capteur capacitif (501 à 504) à un conteneur de marchandises, un plateau ou une place de stockage de marchandises,
b) commande des afficheurs des commutateurs de capteur capacitif (501 à 504) par une unité de commande (509) pour indiquer la quantité de marchandises à prélever,
c) transfert d'un signal à l'unité de commande, indiquant à l'unité de commande qu'un commutateur de capteur capacitif a été touché.
